Europäisches Patentamt

European Patent Office

Office européen des brevets

(11) Publication number: **0 097 814**

**B1**

(12) **EUROPEAN PATENT SPECIFICATION**

(45) Date of publication of patent specification: **11.03.87**

(21) Application number: **83105163.6**

(22) Date of filing: **25.05.83**

(51) Int. Cl.⁴: **H 05 K 7/06**

(54) **Circuit boards.**

(30) Priority: **28.06.82 US 392996**

(43) Date of publication of application:
**11.01.84 Bulletin 84/02**

(45) Publication of the grant of the patent:
**11.03.87 Bulletin 87/11**

(84) Designated Contracting States:
**DE FR GB**

(56) References cited:
**US-A-3 674 914**
**US-A-4 030 190**

**ELECTRONICS, vol. 52, no. 26, December 20,
1979, New York (US) G. MESSNER et al.: "New
multiwire meets the challenge of
interconnecting chip-carriers", 117-121**

(73) Proprietor: **International Business Machines
Corporation
Old Orchard Road
Armonk, N.Y. 10504 (US)**

(72) Inventor: **Varker, Kenneth James
4717 Marshall Drive West
Binghamton New York 13903 (US)**

(74) Representative: **Lewis, Alan John
IBM United Kingdom Limited Intellectual
Property Department Hursley Park
Winchester Hampshire SO21 2JN (GB)**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

## Description

The invention relates to electronic packaging and is more particularly concerned with circuit boards according to the first part of the claim.

There is a great deal of prior art directed to printed circuit boards and to processes for making printed circuit boards. The technology for making large high density printed circuit boards using, plating techniques is well known. For example, see the introduction of U.S. Patent 4,080,513 for a general summary of prior art in this area.

One of the problems encountered when fabricating high density circuit boards is the problem of precisely locating key features of the board after the board has passed through several steps in the fabrication process. For example, the location of circuit lands must be precisely known so that subsequent drilling steps can pass through these lands. Dimensional instability is a particularly severe problem when fabricating multilayer circuit board which go through a series of laminating cycles. For example, U.S. Patent 3,969,177 describes a technique for addressing this problem area. However, as the density and size of the boards being fabricated increases, the need for greater dimensional stability increases so that holes which are subsequently drilled in the board will intersect key features of the board such as lands in the circuit pattern thereby effecting an electrical connection to these features. If the board is not dimensionally stable, these drilled holes may miss the conductive pattern and the board will not function properly.

Most high density circuit boards use epoxy resin laminates which are reinforced with glass cloth. The glass cloth is included in order to provide strength. However, when the epoxy is softened as occurs during subsequent operations such as lamination, the glass cloth tends to move in an irregular and uncontrolled manner, thus the key features in the circuit pattern tend to move in an uncontrolled manner and these features can not be precisely located for subsequent drilling operations.

The technique described in U.S. Patent 4,030,190 (Varker) seeks to eliminate this problem by using a relatively thick sheet of copper to impart dimensional stability instead of relying on the properties of the epoxy glass substrate for dimensional stability.

Patent 4,030,190 (Varker) describes a sequential process for making multilayer circuit boards wherein dimensional stability is achieved during the manufacturing operation by building up the various layers of the board onto a substrate or base plane of copper which has a high degree of dimensional stability. A high density circuit board manufactured using this sequential technique is described in an article by D. P. Seraphim, entitled "A New Set of Printed Circuit Technologies for the IBM 3081 Processor", published in the IBM Journal of Research and Development, Vol. 26, No. 1, January 1982.

An alternative technique for manufacturing circuit boards involves laying down thin insulated wires on a substrate which has been coated with an adhesive. Holes are drilled into the board, cutting the wires at the places where connections are desired. These holes are plated, thereby making connections to the wires. Board made by this process are generally termed encapsulated wire boards. One commercial application of this technology is known by the trade name "Multiwire" (trademark owned by Kollmorgen Corp). This type of technology is, for example, shown in U.S. Patents 4,097,684, (Burr); 3,646,572 (Burr); 3,647,914 (Burr) and 3,674,602 (Keough).

In "Electronics", Volume 52, No. 26, 20 December 1979, pages 117—121, G. Messner describes a "Multiwire" circuit board comprising a layer of adhesive covering a base layer of a glass cloth containing epoxy and wires encapsulated in said adhesive.

The present invention provides a technique for making high density, thermally stable circuit boards using encapsulated wires. The invention combines in a synergistic manner the advantages of prior encapsulated wire or "Multiwire" technology with the technique for making high density dimensionally stable circuit boards shown in U.S. Patent 4,030,190 (Varker).

The technique of the present invention begins with a base layer of a dimensionally stable material such as copper. This base layer not only provides dimensional stability, but it can also serve as a power distribution or ground plane.

A composite formed by laminating epoxy resin pre-preg onto each side of the copper foil. If more than one power or ground plate is desired, the composite can consist of a plurality of layers of copper foil separated from each other by layers of epoxy pre-preg and covered on the outside surfaces with epoxy pre-preg. This composite forms a core or backbone which has a high degree of dimensional stability. Since the pre-preg has very little dimensional stability, the dimensions of the composite during thermal, mechanical or chemical cycling are controlled by the dimensionally stable base layer or material such as copper.

A layer of thermally curable adhesive is applied on the outside of this composite. This adhesive must have two properties. The application of a relatively small amount of energy must soften it so that it can be selectively softened in order to affix wires to the composite. For reasons explained later, the adhesive must also have the property that it can be cured.

The insulated wires are laid down on the adhesive utilizing a wire feed head which softens the adhesive as the wire is being laid down on the adhesive. After the wire head passes, the adhesive is not cured and if the board is thermally, mechanically or chemically cycled, the adhesive would soften and the wires would move relative to the copper foil.

Accordingly the invention provides a circuit board comprising a rigid base plane which returns to a constant shape after being thermally cycled, a layer of epoxy glass cloth pre-preg covering said base plane, the thickness of said layer being such that its lateral movement during thermal cycling is controlled by said rigid base plane, a layer of cured adhesive covering said epoxy, said adhesive being heat curable and having a viscosity curve which at first decreases due to the application of thermal energy and which later rises rapidly as the material cures, wires encapsulated in said cured adhesive, each wire having a U-shaped portion at each location where a connection is to be made to the wire by drilling through said wire with a drill, the distance between the limbs of the U-shaped portion being less than the diameter of said drill, and plated through holes making connections, as aforesaid, to said wire, said holes being drilled and plated after the wires have been encapsulated in the cured adhesive.

After the wires have been laid in the adhesive the adhesive is cured, thereby fixing the wires to the dimensionally stable composite and preventing them from moving relative to the base composite. Since the dimensional changes of the base composite during thermal, mechanical or chemical cycling are controlled by the layer of copper and not by the layers of pre-preg, the wires move in predictable manner during any such cycling.

After the wires have been laid in the adhesive and the adhesive has been cured, holes are drilled at precise predetermined locations in the board. These holes are positioned to intersect the wires at particular locations. Next, these holes are catalyzed and plated, thereby making connections to the wires.

A multilayer structure can be formed by taking several composites which have had wires applied as described above, (but prior to drilling) separating them by layers of pre-preg and then laminating the structure into a high density multilayer encapsulated wire structures. In such a multilayer structure, the holes are drilled after the lamination step.

The invention will now be described in more detail with reference to the accompanying drawings, in which:—

Figure 1 illustrates a layer of copper foil showing the power clearance holes.

Figure 2 illustrates a composite containing a plurality of power cores.

Figure 3 illustrates the properties that the adhesive must have.

Figure 4 illustrates a composite including the layers of adhesive.

Figure 5 illustrates a composite with wires applied. For clarity the wires are shown on the surface of the adhesive.

Figure 6 shows U shapes in the wires and the relative sizes of the holes.

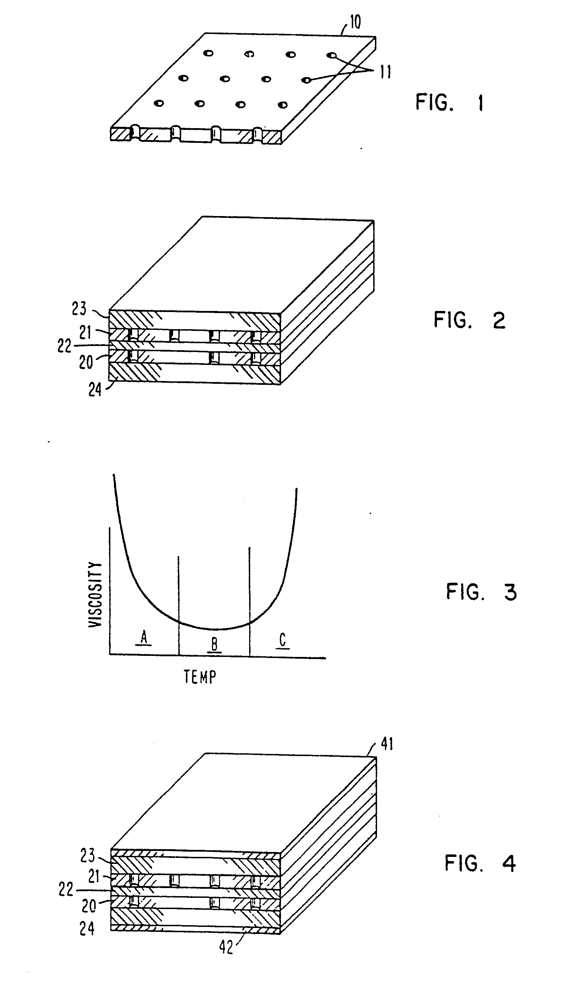

In the particular embodiment shown herein, the base element in the circuit board is a layer of two ounce copper foil 10 shown in Figure 1. This base layer can be copper or any other dimensionally stable material. Boards made in accordance with this invention can include one or more such layers. The circuit described in detail herein has two such layers. The base layer 10 can serve as a ground or power plane for the circuit board. This layer of foil gives the circuit board dimensional stability. The thickness of this layer of foil relative to the thickness of subsequent layers of epoxy glass is chosen so that the expansion and contraction of the circuit board during thermal mechanical or chemical cycling is controlled by the properties of this layer. Clearance holes 11 are drilled in this foil at all locations where connections will be made to the encapsulated wires (except at the locations where it is desired to make connections between the encapsulated wires and the power or ground planes).

The particular embodiment shown here has a power plane 20 and a ground plane 21 in each composite as shown in Figure 2. Power plane 20 and ground plane 21 are separated by a layer of epoxy resin pre-preg 22 and covered by layers of epoxy pre-preg 23 and 24. Epoxy resin pre-preg 22, 23 and 24 is conventional pre-preg which consists of glass cloth impregnated with epoxy. The epoxy pre-preg can for example be formulated as shown in U.S. Patent 4,024,305.

The top and bottom layers of pre-preg 23 and 24 are covered with layers of adhesives 41 and 42 as shown in Figure 4. The adhesive 41 and 42 has the properties shown in the viscosity versus temperature curve given in Figure 3. This curve shows the viscosity of the adhesive as a constant amount of energy is applied. In region A the viscosity decreases. In region B the viscosity is low and in region C the material cures. One particular material that satisfies these requirements is an adhesive designated by the tradename FM238 which is manufactured by the Union Carbide company. Other adhesives which displays a similar viscosity versus time curve could be used.

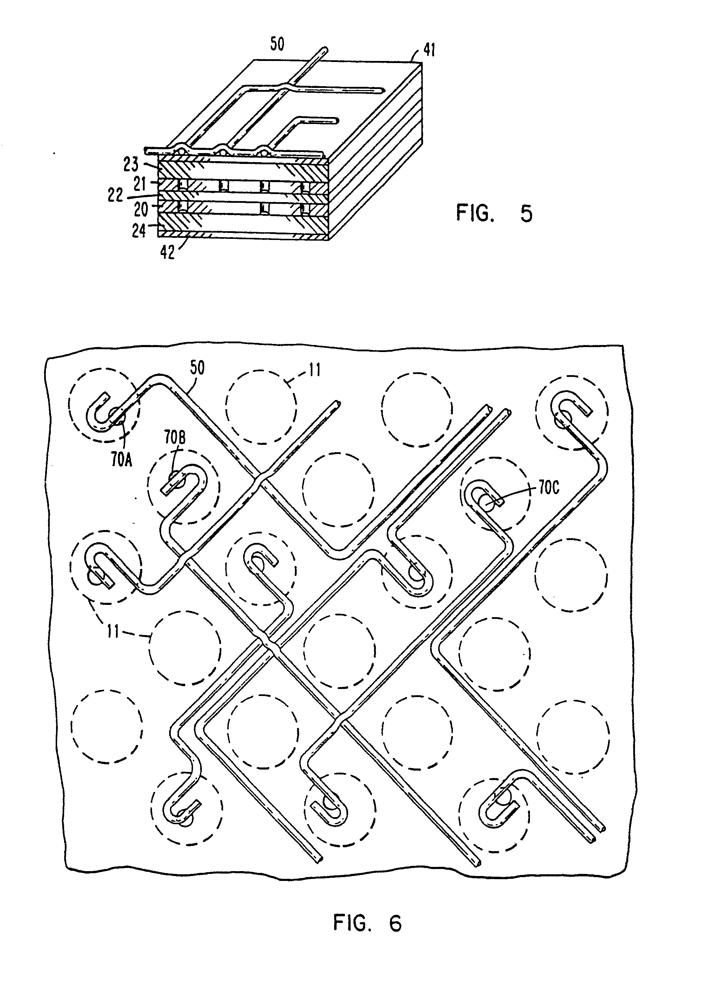

The circuit wires are embedded in the adhesive as shown in Figure 5. This can be done utilizing the type of equipment marketed by Kollmorgen Corporation for the fabrication of "Multiwire" boards. An example of such machinery is described in U.S. patent 3,674,914 (Burr).

After composites have been wired as shown in Figure 5, if a multilayer board is desired several composites can be laminated together to form a multilayer board. The number of composites that can be laminated together is among other considerations limited by the ability to accurately drill small holes through the entire assembly.

At each position where a connection is to be made to a wire 50, the wire is laid in the shape of a U. This is shown in Figure 6. The center line of the wires that form the two legs of the U are separated by 15 mils.

Holes 70 are drilled as shown in Figure 6 at each location where a connection is required to one of the encapsulated wires. The diameter of holes 70 is 0.45 mm (18 mils). Since the legs of the U in the wires 50 is 0.38 mm (15 mils), the drill has a relatively large area over which contact with a wire will be made. This is particularly important in a multilayer board where the drill may have to penetrate a relatively long distance before contacting a wire.

Figure 6 shows in dotted lines the holes 11 in the power and ground planes 20 and 21. It is noted that the size of holes 11 is substantially bigger than the size of holes 70. This insures that there is adequate clearance. The large holes can for example have a diameter of 1.27 mm (50 mils) whereas small holes 11 may have a diameter of 0.45 mm (18 mils).

As shown by the location of holes 11A, 11B, 11C etc. the location of holes 11 due to the U shape in the wires 50 can vary and yet they will make contact with the wires 50. This U shape in the wire ends, allows for significantly increased density since it allows for the use of smaller wires without increasing the risk that a drill will miss encountering the wire. Likewise a small drill can be used without increasing the possibility of missing a wire. These factors combined allow one to space the wires 50 closer together. The combination of greater dimensional stability because the curable adhesive allows the copper layer 10 to control the dimensional stability during thermal cycling together with the U shape in the wires at locations where holes will be drilled allows one to fabricate the high density circuit board of the present invention.

After the holes have been drilled as shown in Figure 6, they are cleaned and catalyzed. This can for example be done using the cleaning technique shown in Patent 4,155,755 and the catalyst shown in U.S. patent 4,066,809. After the holes are cleaned and catalyzed copper is plated in the holes utilizing the electroless bath described in patent 3,844,799. The copper plating makes connections to the wires in a conventional manner thereby completing the circuit board.

The present application comprises subject-matter in common with European patent application No. 0097815, filed on even date herewith, which application claims priority from U.S. application Serial No. 392,997 and is identified by the Applicants reference EN9-82-010.

The present application further comprise subject-matter in common with European patent application No. 0097817, filed on even date herewith, which application claims priority from U.S. application Serial No. 392,998 and is identified by the Applicants reference SA9-82-018.

We have illustrated and described the preferred embodiment of the invention; however, it is to be understood that we do not limit ourselves to the precise construction herein disclosed and the right is reserved to all changes and modifications coming within the scope of the invention as defined by the appended claims.

## Claim

A circuit board comprising a layer (23; 24) of epoxy glass cloth prepreg, a layer (41; 42) of curved adhesive covering the epoxy prepreg layer, wires (50) encapsulated in the cured adhesive, the wires being drilled through at locations where connections are to be made, and the holes (70) being plated through to form bonds with the wire, characterised in that the layer of epoxy glass cloth pre-preg covers a rigid base plane (20; 21) which returns to a constant shape after being thermally cycled, the thickness of the epoxy pre-preg layer being such that its lateral movement during thermal cycling is controlled by the rigid base plane, the adhesive is heat curable and has a viscosity curve which at first decreases due to the application of thermal energy and which later rises rapidly as the material cures, and each wire (50) has a U-shaped portion at each location where a connection is to be made to the wire by drilling through the wire with a drill, each U-shaped portion comprising two spaced parallel limbs and the distance between the limbs of each U-shaped portion being less than the diameter of said drill.

## Patentanspruch

Leiterplatte mit einer Schicht (23; 24) aus einem Epoxy-Glasgewebe-Prepreg, einer Schicht (41; 42) aus gehärtetem Kleber, welche die Epoxy-Prepregschicht abdeckt, in dem gehärteten Kleber gekapselten Drähten (50), wobei die Drähte an Stellen, wo Verbindungen herzustellen sind, durchgebohrt und die Löcher (70) zur Bildung von Verbindungen mit dem Draht durchplattiert sind, dadurch gekennzeichnet, daß die Schicht aus Epoxy-Glasgewebe-Prepreg eine starre Basisfläche (20; 21) abdeckt, welche nach Durchführen durch einen thermischen Zyklus zu einer konstanten Form zurückkehrt, wobei die Dicke der Epoxy-Prepregschicht derart ist, daß ihre seitliche Bewegung während eines Durchführens durch einen thermischen Zyklus durch die starre Basisfläche gesteuert wird, wobei der Kleber wärmehärtbar ist und eine Viskositätskurve hat, welche zunächst infolge des Anwendens von Wärmeenergie abnimmt und später mit dem Härten des Materials rasch ansteigt, und wobei jeder Draht (50) einen U-förmigen Abschnitt an jeder Stelle hat, wo eine Verbindung zum Draht durch Durchbohren des Drahtes mit einem Bohrer herzustellen ist, wobei jeder U-förmige Abschnitt zwei im Abstand liegende parallel Schenkel aufweist und der Abstand zwischen den Schenkeln eines jeden U-förmigen Abschnitts kleiner als der Durchmesser des Bohrers ist.

## Revendication

Plaquette à circuits imprimés comprenant une couche (23; 24) d'une feuille préimprégnée d'un tissu de verre époxy, une couche (41; 42) d'un adhésif durci recouvrant la couche formée de la feuille préimprégnée d'époxy, des fils (5) encapsulés dans l'adhésif durci, les fils étant percés en des emplacements, où des connexions doivent être établies, et les trous (70) étant garnis d'un placage de manière à former des liaisons avec le fil, caractérisé en ce que la couche formée d'une feuille préimpregnée d'un tissu en verre époxy recouvre un plan de base rigide (20; 21), qui reprend une forme constante après avoir été soumis à une sollicitation thermique cyclique, l'épaisseur de la couche formée de la feuille imprégnée d'époxy étant telle que son déplacement latéral pendant la sollicitation thermique cyclique est déterminée par le plan de base rigide, l'adhésif étant durcissable à chaud et posédant une courbe de viscosité qui s'abaisse tout d'abord par suite de l'application d'une énergie thermique et monte ensuite rapidement lorsque la matériau durcit, et chaque fil (5) possède une partie en forme de U au niveau de chaque emplacement où une connexion doit être établie avec le fil par perçage du fil à l'aide d'un foret, chaque partie en forme de U comprenant deux branches distantes paralléles et la distance entre les branches de chaque partie en forme de U étant inférieure au diamètre dudit foret.

FIG. 1

FIG. 2

FIG. 3

FIG. 4

1

FIG. 5

FIG. 6